# EUROPEAN PATENT APPLICATION

(11) **EP 4 535 972 A1**
(43) Date of publication of application: **09.04.2025**
(21) Application number: 24203425.4
(22) Date of filing: 30.09.2024
(51) Int. Cl.: H10K 59/80, H10K 50/844

(54) **DISPLAY DEVICE AND METHOD FOR MANUFACTURING THE SAME**

(30) Priority: 05.10.2023 KR 20230132559
(71) Applicant: Samsung Display Co., Ltd., Gyeonggi-do 17113 (KR)
(72) Inventor: Ha, Jaeheung, 17113 Yongin-si, Gyeonggi-do (KR); Yoon, Hyunsup, 17113 Yongin-si, Gyeonggi-do (KR); Kim, Jongwoo, 17113 Yongin-si, Gyeonggi-do (KR)
(74) Representative: Gulde & Partner

(57) **Abstract**

A display device includes: a display element layer (DL) disposed on a substrate (SUB) and including a light emitting element and an encapsulation member (ENC) disposed on the display element layer and including: a first inorganic encapsulation layer (IEL1), an organic encapsulation layer (OEL) disposed on the first inorganic encapsulation layer, and a second inorganic encapsulation layer (IEL2) including a first seed layer (SL1) disposed on the organic encapsulation layer and a first inorganic layer (IL1) disposed on the first seed layer and having a density less than a density of the first seed layer.

## Description

### BACKGROUND

### 1. Technical Field

Embodiments provide generally to a display device. More particularly, embodiments relate to a display device that provides visual information and a method of manufacturing the display device.

### 2. Description of the Related Art

As information technology develops, the importance of display devices, which are communication media between users and information, is being highlighted. Accordingly, the utilization of display devices such as a liquid crystal display device, an organic light emitting display device, a plasma display device, and the like is increasing.

Meanwhile, a display device, which is thin and flexible, may include a thin film-type encapsulation member to block penetration of moisture or oxygen from the outside. In general, the encapsulation member may include at least one inorganic encapsulation layer and at least one organic encapsulation layer.

### SUMMARY

Embodiments provide a display device including an encapsulation member having a relatively thin thickens.

Embodiments provide a method of manufacturing the display device.

A display device according to embodiments may include a display element layer disposed on a substrate and including a light emitting element and an encapsulation member disposed on the display element layer and including: a first inorganic encapsulation layer, an organic encapsulation layer disposed on the first inorganic encapsulation layer, and a second inorganic encapsulation layer including a first seed layer disposed on the organic encapsulation layer and a first inorganic layer disposed on the first seed layer and having a density less than a density of the first seed layer.

In an embodiment, a difference between the density of the first seed layer and the density of the first inorganic layer may be in a range of about 0.1 g/cm³ or more to about 1 g/cm³ or less, i.e., in a range between 0.1 g/cm³ and 1 g/cm³. Preferably, in a range between 0.2 g/cm³ and 0.9 g/cm³, 0.3 g/cm³ and 0.8 g/cm³, 0.4 g/cm³ and 0.7 g/cm³, or 0.4 g/cm³ and 0.5 g/cm³.

In an embodiment, the second inorganic encapsulation layer may have a thickness of about 4,000 angstroms (Å) or less. Preferably, 3,000 angstroms (Å) or less, 2,000 angstroms (Å) or less, or 1,000 angstroms (Å) or less.

In an embodiment, a thickness of the first seed layer may be about 10% or less of a thickness of the second inorganic encapsulation layer.

In an embodiment, the first inorganic encapsulation layer may include a second seed layer disposed on the display element layer and a second inorganic layer disposed on the second seed layer and having a density less than a density of the second seed layer.

In an embodiment, a difference between the density of the second seed layer and the density of the second inorganic layer may be in a range of about 0.1 g/cm³ or more to about 1 g/cm³ or less. Preferably, in a range between 0.2 g/cm³ and 0.9 g/cm³, 0.3 g/cm³ and 0,8 g/cm³, 0.4 g/cm³ and 0.7 g/cm³, or 0.4 g/cm³ and 0.5 g/cm³.

In an embodiment, the first inorganic encapsulation layer may have a thickness of about 4,000 angstroms (Å) or less.

In an embodiment, a thickness of the second seed layer may be about 10% or less of a thickness of the first inorganic encapsulation layer.

In an embodiment, the first inorganic encapsulation layer may include silicon oxide (SiNₓ) or silicon oxynitride (SiOₓN_{y}), and the second inorganic encapsulation layer may include silicon nitride.

A method of manufacturing a display device according to embodiments may include forming a display element layer including a light emitting element on a substrate, forming a first inorganic encapsulation layer on the display element layer, forming an organic encapsulation layer on the first inorganic encapsulation layer, forming a first seed layer on the organic encapsulation layer by a first deposition process, and forming a second inorganic encapsulation layer by forming a first inorganic layer on the first seed layer by a second deposition process different form the first deposition process.

In an embodiment, the second deposition process may be a plasma enhanced chemical vapor deposition (PECVD) process.

In an embodiment, the first deposition process may be one of a plasma enhanced atomic layer deposition (PEALD) process, a sputtering process, and an E-beam vacuum deposition process.

In an embodiment, a density of the first seed layer may be greater than a density of the first inorganic layer, and a difference between the density of the first seed layer and the density of the first inorganic layer may be in a range of about 0.1 g/cm³ or more to about 1 g/cm³ or less. Preferably, in a range between 0.2 g/cm³ and 0.9 g/cm³, 0.3 g/cm³ and 0.8 g/cm³, 0.4 g/cm³ and 0.7 g/cm³, or 0.4 g/cm³ and 0.5 g/cm³.

In an embodiment, the second inorganic encapsulation layer may have a thickness of about 4,000 angstroms (Å) or less. Preferably, 3,000 angstroms (Å) or less, 2,000 angstroms (Å) or less, or 1,000 angstroms (Å) or less.

In an embodiment, a thickness of the first seed layer may be about 10% or less of a thickness of the second inorganic encapsulation layer.

In an embodiment, the forming the first inorganic encapsulation layer may include forming a second seed layer by the first deposition process and forming a second inorganic layer on the second seed layer by the second deposition process.

In an embodiment, a density of the second seed layer may be greater than a density of the second inorganic layer, and a difference between the density of the second seed layer and the density of the second inorganic layer may be in a range of about 0.1 g/cm³ or more to about 1 g/cm³ or less. Preferably, in a range between 0.2 g/cm³ and 0.9 g/cm³, 0.3 g/cm³ and 0.8 g/cm³, 0.4 g/cm³ and 0.7 g/cm³, or 0.4 g/cm³ and 0.5 g/cm³.

In an embodiment, the first inorganic encapsulation layer may have a thickness of about 4,000 angstroms (Å) or less, and a thickness of the second seed layer may be about 10% or less of a thickness of the first inorganic encapsulation layer.

In an embodiment, the first inorganic encapsulation layer may be formed of silicon oxide or silicon oxynitride, and the second inorganic encapsulation layer may be formed of silicon nitride.

In an embodiment, the first seed layer may be formed of an amino silane-based liquid precursor.

In a display device and a method of manufacturing the same according to embodiments, the display device may include an inorganic encapsulation layer including a seed layer and an inorganic layer having a density less than a density of the seed layer, and covering a display element layer. The seed layer and the inorganic layer may be formed by different deposition processes. Accordingly, the inorganic encapsulation layer with a relatively thin thickness may be formed. For example, the barrier properties of the inorganic encapsulation layer may be improved. Further, to prevent the folding and bending characteristics of the display device from being deteriorated may be possible. In addition, in case that the display device has an OLEDoS (organic light emitting diode on silicon) structure, the occurrence of color mixing may be reduced.

### BRIEF DESCRIPTION OF THE DRAWINGS

Illustrative, non-limiting embodiments will be more clearly understood from the following detailed description in conjunction with the accompanying drawings.
FIG. 1 is a schematic plan view illustrating a display device according to an embodiment.
FIG. 2 is a schematic cross-sectional view schematically illustrating the display device of FIG. 1.
FIG. 3 is an enlarged schematic cross-sectional view of area A of FIG. 2.
FIG. 4 is a schematic cross-sectional view illustrating an example of an encapsulation member of FIG. 3.
FIG. 5 is an enlarged schematic cross-sectional view of area B of FIG. 4.
FIGS. 6, 7, and 8 are schematic cross-sectional views for explaining a method of manufacturing a display device according to an embodiment.
FIG. 9 is a schematic view for explaining the reliability evaluation results of a second inorganic encapsulation layer according to Comparative Example and Embodiment.
FIG. 10 is a graph for explaining the intensity contrast according to the depth of the second inorganic encapsulation layer satisfying Comparative Example 2.
FIG. 11 is a graph for explaining the intensity contrast according to the depth of the second inorganic encapsulation layer satisfying Embodiment 1.
FIG. 12 is a schematic cross-sectional view illustrating another example of the encapsulation member of FIG. 3.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, a display device and a method of manufacturing the same according to embodiments will be explained in detail with reference to the accompanying drawings. The same reference numerals are used for the same components in the drawings, and redundant descriptions of the same components will be omitted.

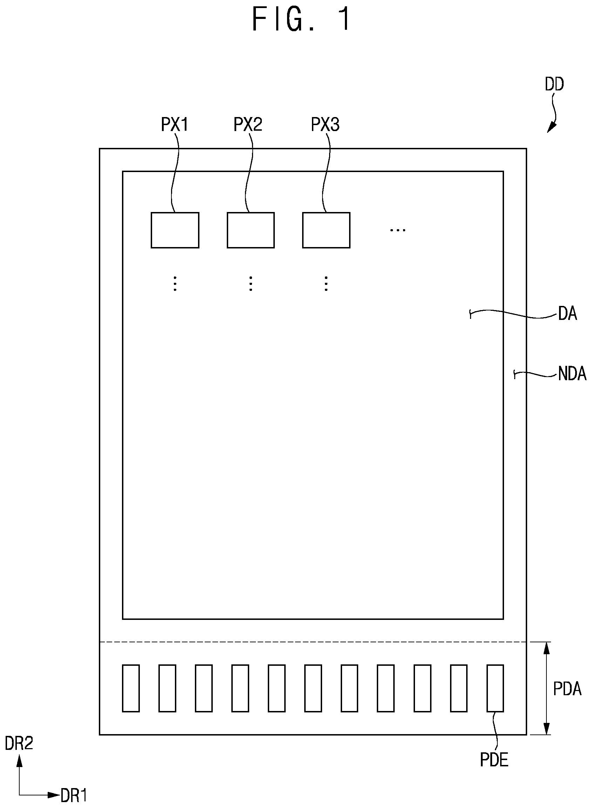

FIG. 1 is a schematic plan view illustrating a display device according to an embodiment.

Referring to FIG. 1, the display device DD according to an embodiment may include a display area DA and a non-display area NDA. The display area DA may be an area that displays an image by generating light or adjusting the transmittance of light provided from an external light source. The non-display area NDA may be an area that does not display images. The non-display area NDA may be positioned around the display area DA. For example, the non-display area NDA may surround (e.g., entirely surround) the display area DA.

Sub-pixels may be disposed in the display area DA. The sub-pixels may be arranged in a matrix form along a first direction DR1 and a second direction DR2 intersecting the first direction DR1. For example, the sub-pixels may include a first sub-pixel PX1, a second sub-pixel PX2, and a third sub-pixel PX3.

Each of the first sub-pixel PX1, the second sub-pixel PX2, and the third sub-pixel PX3 may emit light outward the display device DD through a light emitting element. For example, the first sub-pixel PX1 may emit first light, the second sub-pixel PX2 may emit second light, and the third sub-pixel PX3 may emit third light. In an embodiment, the first light may be red light, the second light may be green light, and the third light may be blue light. However, embodiments are not limited thereto. For example, the first, second, and third sub-pixels PX1, PX2, and PX3 may be combined to emit yellow, cyan, and magenta lights.

The first, second, and third sub-pixels PX1, PX2, and PX3 may emit light of four or more colors. For example, the first, second, and third sub-pixels PX1, PX2, and PX3 may be combined to emit at least one of yellow, cyan, and magenta lights in addition to red light, green light, and blue light. For example, the first, second, and third sub-pixels PX1, PX2, and PX3 may be combined to emit more white light.

In another example, the light emitting elements of the first, second, and third sub-pixels PX1, PX2, and PX3 may emit light of the same color. For example, the light emitting elements of the first, second, and third sub-pixels PX1, PX2, and PX3 may emit blue light. For example, a color conversion layer that converts the wavelength of light emitted from the light emitting elements may be additionally disposed on the first, second, and third sub-pixels PX1, PX2, and PX3. Accordingly, first, second, and third light emitting areas where the first, second, and third sub-pixels PX1, PX2, and PX3 are respectively disposed may emit red light, green light, and blue light, respectively.

In another example, the light emitting elements of the first, second, and third sub-pixels PX1, PX2, and PX3 may emit white light. For example, a color filter layer that selectively transmits light of a specific color may be additionally disposed on the first, second, and third sub-pixels. Accordingly, the first, second, and third light emitting areas where the first, second, and third sub-pixels PX1, PX2, and PX3 are respectively disposed may emit red light, green light, and blue light, respectively.

Each of the first sub-pixel PX1, the second sub-pixel PX2, and the third sub-pixel PX3 may have a triangular planar shape, a square planar shape, a hexagonal planar shape, a circular planar shape, an oval planar shape, or the like. In an embodiment, each of the first sub-pixel PX1, the second sub-pixel PX2, and the third sub-pixel PX3 may have a rectangular planar shape. However, embodiments are not limited thereto. For example, each of the first sub-pixel PX1, the second sub-pixel PX2, and the third sub-pixel PX3 may have a different planar shape.

The non-display area NDA may include a pad area PDA. The pad area PDA may be positioned away from a side of the display area DA. For example, the pad area PDA may have a shape extending in the first direction DR1.

A plurality of lines may be disposed in the non-display area NDA, and pad electrodes PDE may be disposed in the pad area PDA. The plurality of lines may electrically connect pad electrodes PDE and the sub-pixels. For example, the lines may include data signal lines, scan signal lines, light emitting control signal lines, power voltage lines, and the like.

The pad electrodes PDE may be arranged to be spaced apart from each other in the first direction DR1. For example, each of the pad electrodes PDE may include metal, alloy, metal nitride, conductive metal oxide, transparent conductive material, and the like. These may be used alone or in combination with each other.

In the description, a plane may be defined as the first direction DR1 and the second direction DR2 intersecting the first direction DR1. For example, the first direction DR1 may be perpendicular to the second direction DR2.

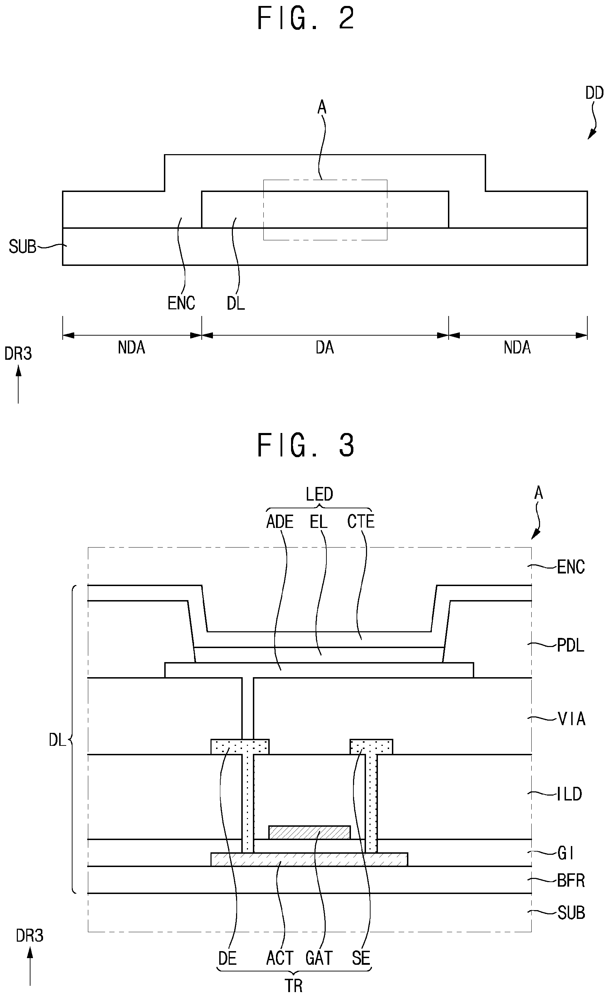

FIG. 2 is a schematic cross-sectional view illustrating the display device of FIG. 1.

Referring to FIG. 2, the display device DD may include a substrate SUB, a display element layer DL disposed on the substrate SUB, and an encapsulation member ENC covering the display element layer DL. For example, the display element layer DL may be disposed on the substrate SUB in a third direction DR3, and the encapsulation member ENC may be disposed on the display element layer DL in the third direction DR3. The third direction DR3 may be perpendicular to the plane defined by the first direction DR1 and the second direction DR2 of FIG. 1.

The substrate SUB may include a transparent material or an opaque material. The substrate SUB may be made of a transparent resin substrate. Examples of the transparent resin substrate may include a polyimide substrate. For example, the polyimide substrate may include a first organic layer, a first barrier layer, a second organic layer, and the like. In another example, the substrate SUB may include a quartz substrate, synthetic quartz substrate, calcium fluoride substrate, F-doped quartz substrate, soda-lime glass substrate, a non-alkali glass substrate, and the like. These may be used alone or in combination with each other. In another example, the substrate SUB may include a silicon wafer.

The display element layer DL may be disposed in the display area DA. The display element layer DL may include a circuit element layer and a light emitting element layer disposed on the circuit element layer. The light emitting element layer may include at least one driving transistor. The light emitting element layer may be electrically connected to the driving transistor and may include a light emitting element that generates light based on a driving signal received through the driving transistor. A detailed description of the display element layer DL will be described later.

The encapsulation member ENC may include at least one inorganic encapsulation layer and at least one organic encapsulation layer. The encapsulation member ENC may prevent moisture and oxygen from penetrating (or permeating) into the light emitting element (e.g., the light emitting element LED of FIG. 3) from the outside. A detailed description of the encapsulation member ENC will be provided later.

FIG. 3 is an enlarged schematic cross-sectional view of area A of FIG. 2. For example, FIG. 3 is an enlarged schematic cross-sectional view of a part of the display element layer DL of FIG. 2.

Referring to FIG. 3, the display element layer DL may include a buffer layer BFR, a transistor TR, a gate insulating layer GI, an interlayer insulating layer ILD, a via insulating layer VIA, a pixel defining layer PDL, and a light emitting element LED.

For example, the transistor TR may include an active pattern layer ACT, a gate electrode GAT, a source electrode SE, and a drain electrode DE, and the light emitting element LED may include an anode electrode ADE, a light emitting layer EL, and a cathode electrode CTE.

The buffer layer BFR may be disposed on the substrate SUB. The buffer layer BFR may prevent metal atoms or impurities from diffusing from the substrate SUB to the transistor TR. For example, the buffer layer BFR may improve the flatness of the surface of the substrate SUB in case that the surface of the substrate SUB is not uniform. For example, the buffer layer BFR may include an inorganic material such as silicon oxide (SiOₓ), silicon nitride (SiNₓ), silicon oxynitride (SiOₓN_{y}), and the like. These may be used alone or in combination with each other.

The active pattern layer ACT may be disposed on the buffer layer BFR. The active pattern layer ACT may include a metal oxide semiconductor, an inorganic semiconductor (e.g., amorphous silicon, poly silicon, and the like), or an organic semiconductor. The active pattern layer ACT may include a source region, a drain region, and a channel region positioned between the source region and the drain region.

The metal oxide semiconductor may include a binary compound (ABₓ), a ternary compound (ABₓC_{y}), a quaternary compound (ABₓC_{y}D_{z}), and the like including indium (In), zinc (Zn), gallium (Ga), tin (Sn), titanium (Ti), aluminum (Al), hafnium (Hf), zirconium (Zr), magnesium (Mg), and the like. For example, the metal oxide semiconductor may include zinc oxide (ZnOₓ), gallium oxide (GaOₓ), tin oxide (SnOₓ), indium oxide (InOₓ), indium gallium oxide (IGO), indium zinc oxide (IZO), indium tin oxide. (ITO), indium zinc tin oxide (IZTO), indium gallium zinc oxide (IGZO), and the like. These may be used alone or in combination with each other.

The gate insulating layer GI may be disposed on the buffer layer BFR. The gate insulating layer GI may cover (e.g., entirely cover) the active pattern layer ACT and may have a substantially flat upper surface without creating a step around the active pattern layer ACT. In another example, the gate insulating layer GI may cover the active pattern layer ACT and may be disposed along the profile of the active pattern layer ACT with a uniform thickness. For example, the gate insulating layer GI may include an inorganic material such as silicon oxide (SiOₓ), silicon nitride (SiNₓ), silicon carbide (SiCₓ), silicon oxynitride (SiOₓN_{y}), silicon oxycarbide (SiOₓC_{y}), and the like. These may be used alone or in combination with each other.

The gate electrode GAT may be disposed on the gate insulating layer GI. The gate electrode GAT may overlap the channel area of the active pattern layer ACT The gate electrode GAT may include metal, alloy, metal nitride, conductive metal oxide, transparent conductive material, and the like. Examples of the metal may include silver (Ag), molybdenum (Mo), aluminum (Al), tungsten (W), copper (Cu), nickel (Ni), chromium (Cr), titanium (Ti), and tantalum (Ta), platinum (Pt), scandium (Sc), and the like. Examples of the conductive metal oxide may include indium tin oxide and indium zinc oxide. For example, examples of the metal nitride include aluminum nitride (AlNₓ), tungsten nitride (WNₓ), chromium nitride (CrNₓ), and the like. These may be used alone or in combination with each other.

The interlayer insulating layer ILD may be disposed on the gate insulating layer GI. The interlayer insulating layer ILD may cover (e.g., entirely cover) the gate electrode GAT and may have a substantially flat upper surface without creating step differences around the gate electrode GAT. In another example, the interlayer insulating layer ILD may cover the gate electrode GAT and may be disposed along the profile of the gate electrode GAT with a uniform thickness. For example, the interlayer insulating layer ILD may include an inorganic material such as silicon oxide, silicon nitride, silicon carbide, silicon oxynitride, silicon oxycarbide, and the like. These may be used alone or in combination with each other.

The source electrode SE and the drain electrode DE may be disposed on the interlayer insulating layer ILD. The source electrode SE may be connected to the source region of the active pattern layer ACT through a contact hole penetrating a first part of the gate insulating layer GI and the interlayer insulating layer ILD, and the drain electrode DE may be connected to the drain region of the active pattern layer ACT through a contact hole penetrating a second part of the gate insulating layer GI and the interlayer insulating layer ILD. For example, each of the source electrode SE and the drain electrode DE may include a metal, alloy, metal nitride, conductive metal oxide, transparent conductive material, and the like. These may be used alone or in combination with each other.

Accordingly, the transistor TR including the active pattern layer ACT, the gate electrode GAT, the source electrode SE, and the drain electrode DE may be disposed in the display area DA on the substrate SUB.

The via insulating layer VIA may be disposed on the interlayer insulating layer ILD. The via insulating layer VIA may cover (e.g., entirely cover) the source electrode SE and the drain electrode DE. The via insulation layer VIA may include an inorganic material or an organic material. In an embodiment, the via insulating layer VIA may include an organic material. For example, the via insulating layer VIA may include an organic material such as phenolic resin, polyacrylates resin, polyimides resin, polyamides resin, siloxane resin, epoxy resin, and the like. These may be used alone or in combination with each other.

The anode electrode ADE may be disposed on the via insulating layer VIA. The anode electrode ADE may be connected to the drain electrode DE (or source electrode SE) through a contact hole penetrating the via insulating layer VIA. For example, the anode electrode ADE may include metal, alloy, metal nitride, conductive metal oxide, transparent conductive material, and the like. These may be used alone or in combination with each other. In an embodiment, the anode electrode ADE may have a layered structure including ITO/Ag/ITO. However, embodiments are not limited thereto.

The pixel defining layer PDL may be disposed on the via insulating layer VIA. The pixel defining layer PDL may cover the edge portion of the anode electrode ADE. For example, an opening exposing at least a part of the upper surface of the anode electrode ADE may be defined in the pixel defining layer PDL. For example, the pixel defining layer PDL may include an inorganic material or an organic material. In an embodiment, the pixel defining layer PDL may include an organic material such as epoxy resin, siloxane resin, and the line. These may be used alone or in combination with each other. In another embodiment, the pixel defining layer PDL may include an inorganic material and/or an organic material including a light blocking material such as black pigment, black dye, and the like.

The light emitting layer EL may be disposed on the anode electrode ADE. For example, the light emitting layer EL may be disposed in the opening of the pixel defining layer PDL. The light emitting layer EL may include an organic material that emits light of a certain color. For example, the light emitting layer EL may include an organic material that emits red light, green light, or blue light.

The cathode electrode CTE may be disposed on the pixel defining layer PDL and the light emitting layer EL. For example, the cathode electrode CTE may include metal, alloy, metal nitride, conductive metal oxide, transparent conductive material, and the like. These may be used alone or in combination with each other.

In another example, a capping layer may be further disposed between the cathode electrode CTE and the encapsulation member ENC. For example, the capping layer may include an inorganic material such as silicon oxide, silicon nitride, and the like. These may be used alone or in combination with each other.

Accordingly, the light emitting element LED including the anode electrode ADE, the light emitting layer EL, and the cathode electrode CTE may be disposed in the display area DA on the substrate SUB. The light emitting element LED may be electrically connected to the transistor TR. Accordingly, the light emitting element LED may receive a driving signal from the transistor TR and generate light based on the driving signal.

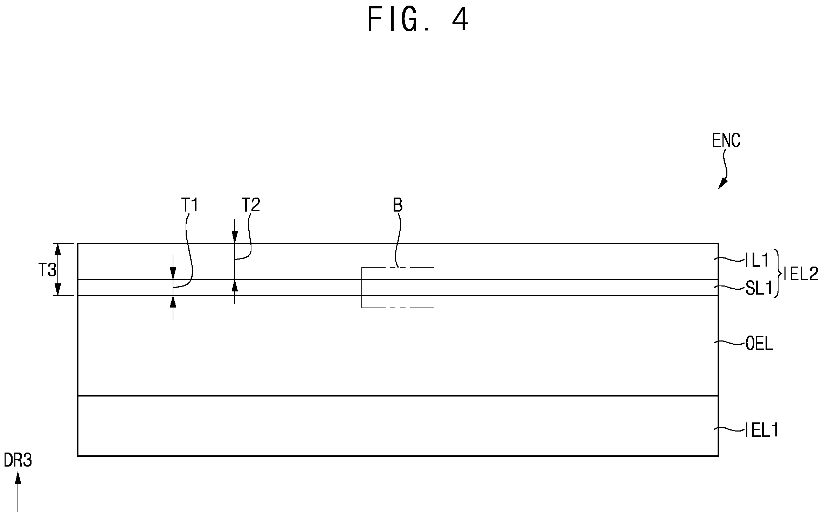

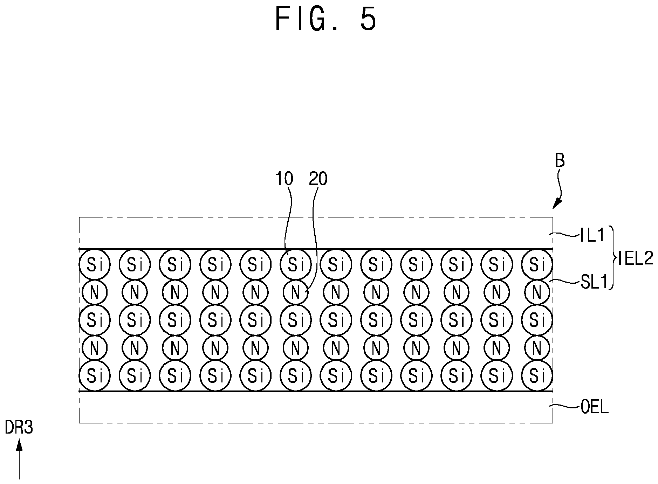

FIG. 4 is a schematic cross-sectional view illustrating an example of an encapsulation member of FIG. 3. FIG. 5 is an enlarged schematic cross-sectional view of area B of FIG. 4. For example, FIG. 5 is an enlarged schematic cross-sectional view of a part of a first seed layer SL1 of FIG. 4.

Referring to FIG. 4, the encapsulation member ENC may include a first inorganic encapsulation layer IEL1, an organic encapsulation layer OEL disposed on the first inorganic encapsulation layer IEL1, and a second inorganic encapsulation layer IEL2 disposed on the organic encapsulation layer OEL.

The first inorganic encapsulation layer IEL1 may include a silicon compound. For example, the first inorganic encapsulation layer IEL1 may include silicon oxide, silicon nitride, silicon oxynitride, and the like. These may be used alone or in combination with each other. In an embodiment, the first inorganic encapsulation layer IEL1 may include silicon nitride. In another embodiment, the first inorganic encapsulation layer IEL1 may include silicon oxynitride. However, embodiments are not limited thereto. For example, a thickness of the first inorganic encapsulation layer IEL1 in the third direction DR3 may be in the range of about 7,000 angstroms (Å) or more.

The organic encapsulation layer OEL may have a substantially flat upper surface. For example, the organic encapsulation layer OEL may include a cured polymer such as polyacrylate and the like. However, embodiments are not limited thereto. For example, a thickness of the organic encapsulation layer OEL in the third direction DR3 may be in the range of about 30,000 angstroms (Å) to about 50,000 angstroms (Å).

The second inorganic encapsulation layer IEL2 may include a silicon compound. For example, the second inorganic encapsulation layer IEL2 may include silicon oxide, silicon nitride, silicon oxynitride, and the like. These may be used alone or in combination with each other. In an embodiment, the second inorganic encapsulation layer IEL2 may include silicon nitride.

The second inorganic encapsulation layer IEL2 may be separated into two layers. In an embodiment, the second inorganic encapsulation layer IEL2 may include the first seed layer SL1 disposed on the organic encapsulation layer OEL and a first inorganic layer IL1 disposed on the first seed layer SL1. For example, the first seed layer SL1 may contact (e.g., directly contact) the organic encapsulation layer OEL, and the first inorganic layer IL1 may contact (e.g., directly contact) the first seed layer SL1. The first seed layer SL1 may be formed before the first inorganic layer IL1 by a separate deposition process. A detailed description of this will be provided later.

A density of the first inorganic layer IL1 may be less than a density of the first seed layer SL1. For example, the density of the first seed layer SL1 may be greater than the density of the first inorganic layer IL1. For example, the density of the first seed layer SL1 may be in a range of about 1.9 g/cm³ or more to about 3.5 g/cm³ or less. For example, the density of the first seed layer SL1 may be in a range of about 2.14 g/cm³ or more to about 2.7 g/cm³ or less. For example, the density of the first inorganic layer IL1 may be in a range of about 1.8 g/cm³ or more to about 3.5 g/cm³ or less. For example, the density of the first inorganic layer IL1 may be in a range of about 1.9 g/cm³ or more to about 2.04 g/cm³ or less.

For example, the density of each of the first seed layer SL1 and the first inorganic layer IL1 may be measured using an x-ray reflection (XRR) method.

In an embodiment, a difference between the density of the first seed layer SL1 and the density of the first inorganic layer IL1 may be in the range of about 0.1 g/cm³ or more. For example, the difference between the density of the first seed layer SL1 and the density of the first inorganic layer IL1 may be in the range of about 0.1 g/cm³ or more to about 1 g/cm³ or less.

Referring further to FIG. 5, as described above, in case that the first seed layer SL1 is first formed by a deposition process separate from the first inorganic layer IL1, the first seed layer SL1 may be formed as a uniform and dense layer. For example, silicon atoms 10 and nitrogen atoms 20 of the first seed layer SL1 may be arranged uniformly and densely. For example, the silicon atoms 10 and the nitrogen atoms 20 of the first seed layer SL1 may be alternately arranged in the vertical direction (e.g., third direction DR3). For example, the silicon atoms 10 of the first seed layer SL1 may be arranged to be adjacent to each other in a horizontal direction (e.g., first direction DR1 or second direction DR2). For example, the nitrogen atoms 20 of the first seed layer SL1 may be arranged adjacent to each other in a horizontal direction (e.g., first direction DR1 or second direction DR2). Accordingly, the barrier properties of the second inorganic encapsulation layer IEL2 may be improved.

Referring again to FIG. 4, for example, a thickness T3 of the second inorganic encapsulation layer IEL2 may be in the range of about 4,000 angstroms (Å) or less. For example, in case that the difference between the density of the first seed layer SL1 and the density of the first inorganic layer IL1 is in the range of about 0.1 g/cm³ or more to about 1 g/cm³ or less, the thickness T3 of the second inorganic encapsulation layer IEL2 may be in the range of about 4,000 Angstroms (Å) or less. Accordingly, the second inorganic encapsulation layer IEL2 may have a thickness smaller than a thickness of the first inorganic encapsulation layer IEL1.

For example, the thickness T3 of the second inorganic encapsulation layer IEL2 may denote the sum of a thickness T1 of the first seed layer SL1 and a thickness T2 of the first inorganic layer IL1. For example, the thickness T1, T2, or T3 of each layer may denote the length in the third direction DR3.

In an embodiment, the thickness T1 of the first seed layer SL1 may be about 10% or less of the thickness T3 of the second inorganic encapsulation layer IEL2. For example, the thickness T1 of the first seed layer SL1 may be in the range of about 400 angstroms (Å) or less. For example, the thickness T1 of the first seed layer SL1 may be about 0.01% or more to about 10% or less of the thickness T3 of the second inorganic encapsulation layer IEL2. In case that the thickness T1 of the first seed layer SL1 exceeds about 10% of the thickness T3 of the second inorganic encapsulation layer IEL2, mass productivity may decrease due to a decrease in tact time (or manufacturing time).

However, embodiments are not limited thereto, and the second inorganic encapsulation layer IEL2 may be disposed under the organic encapsulation layer OEL, and the first inorganic encapsulation layer IEL1 may be disposed under the organic encapsulation layer OEL. For example, the order of the first inorganic encapsulation layer IEL1 and the second inorganic encapsulation layer IEL2 may be changed.

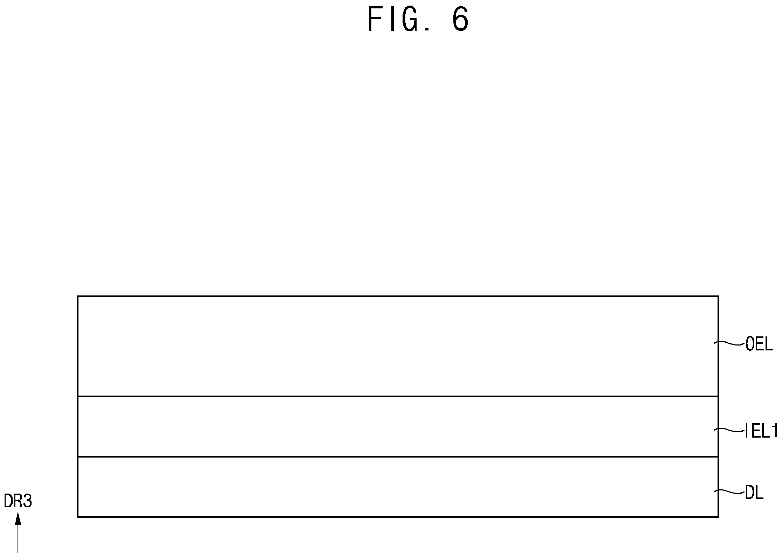

FIGS. 6, 7, and 8 are schematic cross-sectional views for explaining a method of manufacturing a display device according to an embodiment.

Referring to FIG. 6, the display element layer DL may be formed on a substrate (e.g., the substrate SUB of FIG. 3). The display element layer DL may include a circuit element layer including a driving transistor and a light emitting element layer including a light emitting element electrically connected to the driving transistor.

The first inorganic encapsulation layer IEL1 may be formed on the display element layer DL. For example, the first inorganic encapsulation layer IEL1 may be formed of silicon nitride, silicon oxynitride, and the like. For example, the first inorganic encapsulation layer IEL1 may be formed by a plasma enhanced chemical vapor deposition (PECVD) process. However, embodiments are not limited thereto.

The organic encapsulation layer OEL may be formed on the first inorganic encapsulation layer IEL1. For example, the organic encapsulation layer OEL may be formed by supplying organic materials by an inkjet printing process. However, embodiments are not limited thereto.

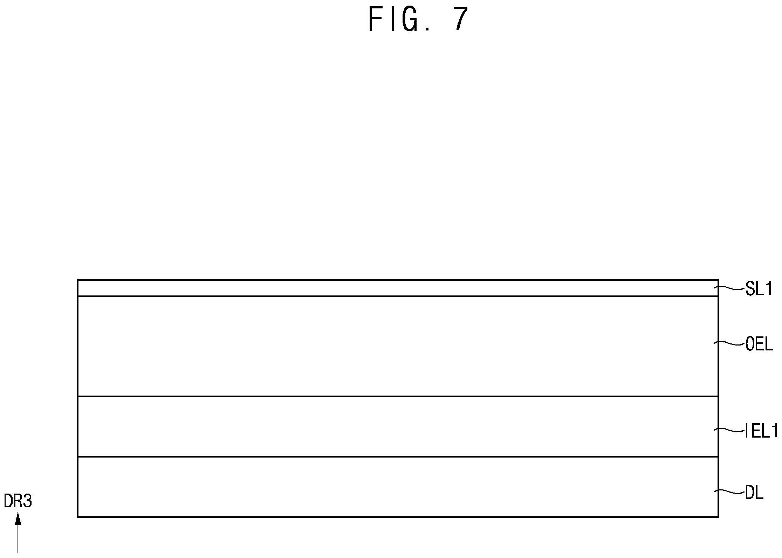

Referring to FIG. 7, the first seed layer SL1 may be formed on the organic encapsulation layer OEL. The first seed layer SL1 may be formed of a silicon compound. For example, the first seed layer SL1 may be formed of silicon nitride.

In an embodiment, the first seed layer SL1 may be formed by a first deposition process. For example, the first deposition process may be one of a plasma enhanced atomic layer deposition (PEALD) process, a sputtering process, and an E-beam vacuum deposition process. However, embodiments are not limited thereto.

In an embodiment, the first seed layer SL1 may be formed of an amino silane-based liquid precursor. For example, the first deposition process may be a plasma enhanced atomic layer deposition process. For example, the liquid precursor may include cyclosilazane, trisilyamine, bis(diethylamino)silane, bis(tert-butylamino)silane, tris(dimethylamino)silane), tris(isopropylamino)silane), tetrakis(dimethylamino)silane), tri(isopropyl)cyclotrisilazane, tetramethyldisilazane, and the like. These may be used alone or in combination with each other. However, embodiments are not limited thereto.

In case of forming the first seed layer SL1 using the amino silane-based liquid precursor, the density may be relatively higher compared to forming the first seed layer SL1 using the silane-based precursor. For example, the deposition rate in the formation of the first seed layer SL1 using the amino silane-based liquid precursor may be higher than the deposition rate in the formation of the first seed layer SL1 using the silane-based precursor.

For example, in relation to the process of forming the first seed layer SL1, in case that the first deposition process is a plasma enhanced atomic layer deposition process, an amino silane-based liquid precursor may be supplied on the organic encapsulation layer OEL. For example, the amino silane-based liquid precursor may be purged from a chamber. Reaction gases may then be purged from the chamber. For example, the reaction gases may include oxygen (O₂), ozone (O₃), nitrogen monoxide (NO), nitrogen dioxide (N₂O), and the like. These may be used alone or in combination with each other. By repeatedly performing the above process, the first seed layer SL1 of a desired thickness may be formed.

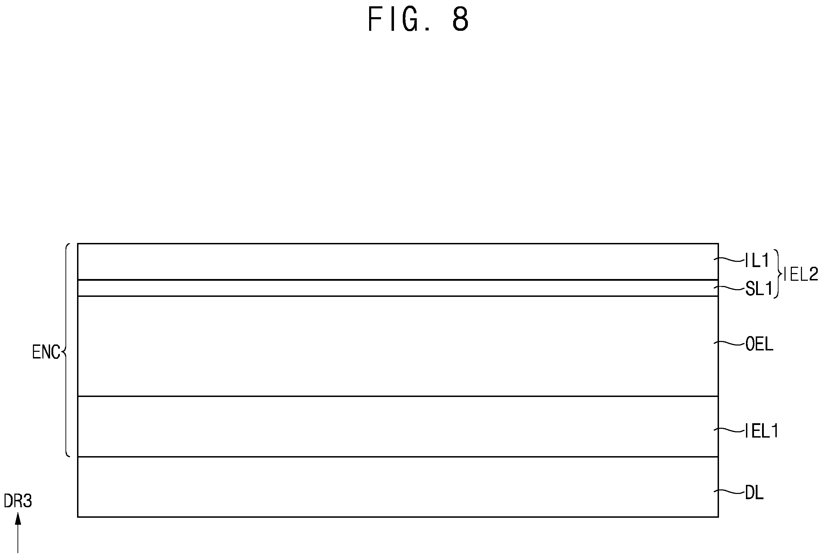

Referring to FIG. 8, the first inorganic layer IL1 may be formed on the first seed layer SL1. The first inorganic layer IL1 may be formed of a silicon compound. For example, the first inorganic layer IL1 may be formed of silicon nitride.

In an embodiment, the first inorganic layer IL1 may be formed by a second deposition process different from the first deposition process. For example, the second deposition process may be a plasma enhanced chemical vapor deposition process. However, embodiments are not limited thereto.

In an embodiment, the first inorganic layer IL1 may be formed of a silane-based precursor or an amino silane-based liquid precursor. An example of the liquid precursor used in the first inorganic layer IL1 may be the same as an example of the liquid precursor used in the first seed layer SL1.

The density of the first inorganic layer IL1 may be less than the density of the first seed layer SL1. In an embodiment, the difference between the density of the first seed layer SL1 and the density of the first inorganic layer IL1 may be in the range of about 0.1 g/cm³ or more. For example, the difference between the density of the first seed layer SL1 and the density of the first inorganic layer IL1 may be in the range of about 0.1 g/cm³ or more to about 1 g/cm³ or less.

Accordingly, the second inorganic encapsulation layer IEL2 including the first seed layer SL1 and the first inorganic layer IL1 may be formed on the organic encapsulation layer OEL.

For example, referring again to FIG. 4, the thickness T3 of the second inorganic encapsulation layer IEL2 may be in the range of about 4,000 angstroms (Å) or less. For example, the thickness T1 of the first seed layer SL1 may be about 10% or less of the thickness T3 of the second inorganic encapsulation layer IEL2. For example, the thickness T1 of the first seed layer SL1 may be about 0.01% or more to about 10% or less of the thickness T3 of the second inorganic encapsulation layer IEL2.

As the second inorganic encapsulation layer IEL2 is formed, the encapsulation member ENC including the first inorganic encapsulation layer IEL1, the organic encapsulation layer OEL, and the second inorganic encapsulation layer IEL2 may be formed. As the encapsulation member ENC is formed, the display device DD of FIGS. 1 and 2 may be manufactured.

Referring again to FIGS. 1, 2, 3, 4, 5, 6, 7, and 8, the display device DD according to embodiments may include the second inorganic encapsulation layer IEL2 including the first seed layer SL1 and the first inorganic layer IL1 having a density less than a density of the first seed layer SL1, and covering the display element layer DL. The first seed layer SL1 and the first inorganic layer IL1 may be formed by different deposition processes.

Accordingly, the second inorganic encapsulation layer IEL2 having a relatively thin thickness may be formed. Thus, the barrier properties of the second inorganic encapsulation layer IEL2 may be improved, thereby preventing the folding and bending characteristics of the display device DD from being deteriorated. For example, in case that the display device DD has an OLEDoS (organic light emitting diode on silicon) structure, the occurrence of color mixing may be reduced.

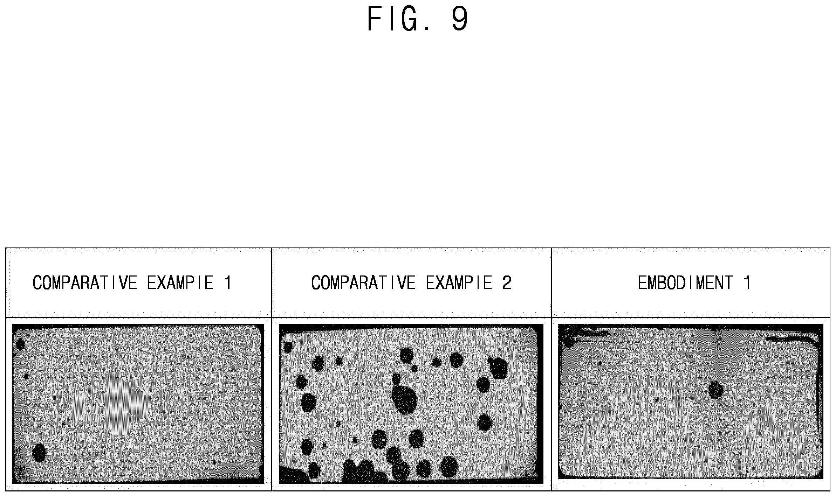

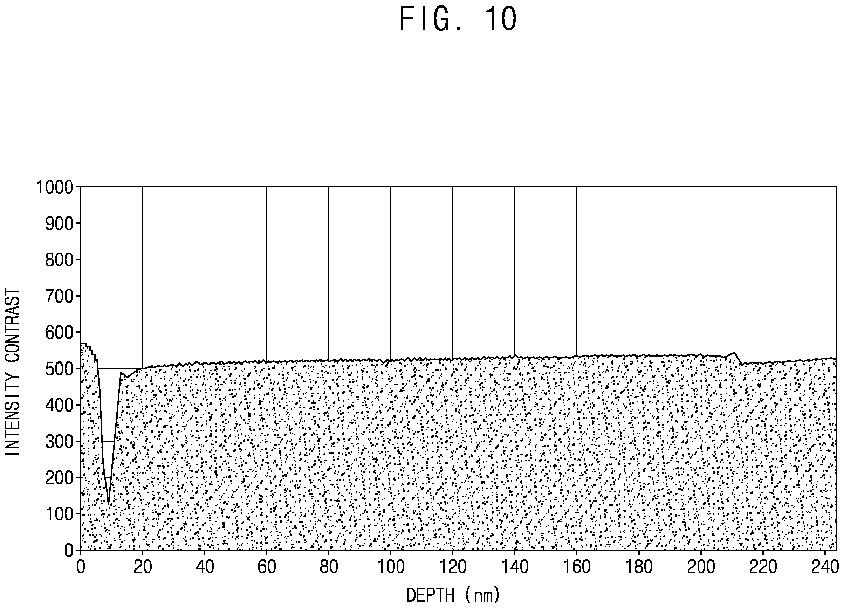

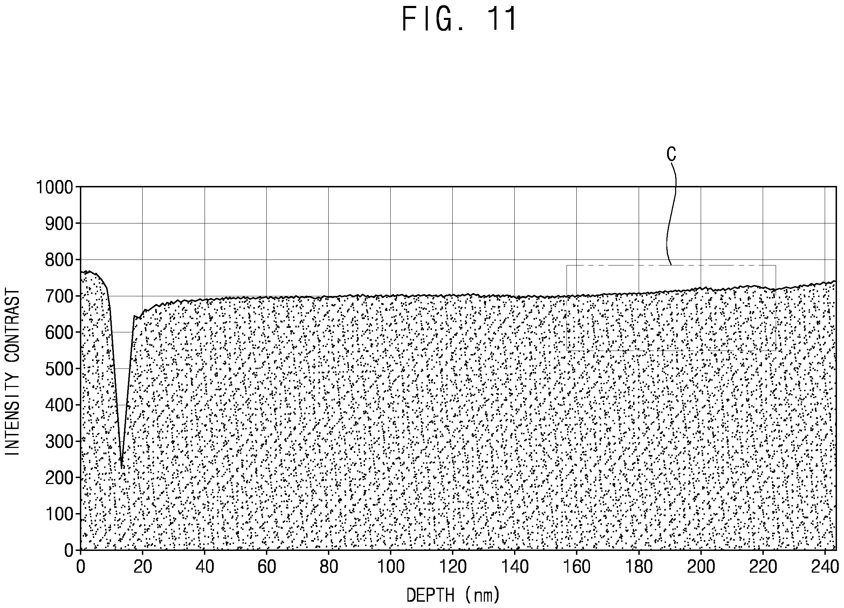

FIG. 9 is a schematic view for explaining the reliability evaluation results of a second inorganic encapsulation layer according to Comparative Examples 1 and 2 and Embodiment 1. FIG. 10 is a graph for explaining the intensity contrast according to the depth of the second inorganic encapsulation layer satisfying Comparative Example 2. FIG. 11 is a graph for explaining the intensity contrast according to the depth of the second inorganic encapsulation layer satisfying Embodiment 1.

In Comparative Example 1, a second inorganic encapsulation layer including silicon nitride and having a thickness of about 7,000 angstroms (Å) may be formed on a silicon wafer. For example, the second inorganic encapsulation layer may be formed by a plasma chemical vapor deposition process. For example, the second inorganic encapsulation layer may include an inorganic layer positioned on an uppermost layer of an encapsulation member ENC.

In Comparative Example 2, a second inorganic encapsulation layer including silicon nitride and having a thickness of about 2,000 angstroms (Å) may be formed on a silicon wafer. For example, the second inorganic encapsulation layer may be formed by a plasma chemical vapor deposition process. For example, the second inorganic encapsulation layer may include an inorganic layer positioned on an uppermost layer of an encapsulation member ENC.

In Embodiment 1, the second inorganic encapsulation layer IEL2 including silicon nitride and including the first seed layer SL1 having a thickness of about 10 angstroms (Å) and the first inorganic layer IL1 having a thickness of about 2,000 angstroms (Å) may be formed on a silicon wafer. For example, the first seed layer SL1 may be formed by a plasma enhanced atomic layer deposition process, and the first inorganic layer IL1 may be formed by a plasma enhanced chemical vapor deposition process. For example, the second inorganic encapsulation layer IEL2 may include an inorganic layer positioned on an uppermost layer of the encapsulation member ENC.

In Comparative Example 1, Comparative Example 2, and Embodiment 1, the reliability of the second inorganic encapsulation layer may be evaluated using UHAST (unbiased highly accelerated stress test). For example, the photo shown in FIG. 9 is a photo taken after exposing the second inorganic encapsulation layer to high temperature (e.g., about 85 degrees) and high humidity (e.g., about 85%) conditions for about 504 hours.

As a result, referring to FIG. 9, the second inorganic encapsulation layer IEL2 satisfying Embodiment 1 may have a substantially similar level of reliability compared to the second inorganic encapsulating layer satisfying Comparative Example 1. For example, the second inorganic encapsulation layer IEL2 satisfying Embodiment 1 may have improved reliability compared to the second inorganic encapsulating layer satisfying Comparative Example 2.

For example, referring to FIG. 11, the intensity contrast according to depth of the second inorganic encapsulation layer IEL2 satisfying Embodiment 1 may have a slope in area C of the graph. Referring to FIG. 10, there may not have any slope in an area corresponding to the area C (i.e., the area having the same depth range as area C) of the graph of the intensity contrast according to the depth of the second inorganic encapsulation layer satisfying Comparative Example 2. Thus, the second inorganic encapsulation layer IEL2 satisfying Embodiment 1 may include a first seed layer SL1.

In FIGS. 10 and 11, the depth of the second inorganic encapsulation layer that exceeds the thickness of the second inorganic encapsulation layer may correspond to the depth of the silicon wafer. For example, the intensity contrast refers to the relative value of contrast observed through a TEM (transmission electron microscope).

Hereinafter, the barrier properties of the second inorganic encapsulation layer according to Comparative Example 3 and Embodiment 2 will be described.

Referring to Table 1 below, in Comparative Example 3, a second inorganic encapsulation layer including silicon nitride and having a thickness of about 10,000 angstroms (Å) may be formed on a silicon wafer. For example, the second inorganic encapsulation layer may be formed by a plasma chemical vapor deposition process. For example, the second inorganic encapsulation layer may include an inorganic layer positioned on an uppermost layer of the encapsulation member ENC.

In Embodiment 2, the second inorganic encapsulation layer IEL2 including silicon nitride and having a thickness of about 10,000 angstroms (Å) may be formed on a silicon wafer. For example, the second inorganic encapsulation layer IEL2 may include the first seed layer SL1 formed by a plasma enhanced atomic layer deposition process and the first inorganic layer IL1 formed by a plasma enhanced chemical vapor deposition process on the first seed layer SL1. For example, the second inorganic encapsulation layer IEL2 may include an inorganic layer positioned on the uppermost layer of the encapsulation member ENC.

According to Comparative Example 3 and Embodiment 2, the water vapor transmission rate (WVTR) of the second inorganic encapsulation layer may be measured.

**<Table 1>**

| | Comparative Example 3 | Embodiment 2 |
|---|---|---|
| Thickness (Å) | 10,000 | 10,000 |
| WVTR(g/m²-day) | 3.0 × 10⁻⁴ | 5.0 × 10⁻⁵ or less |

As a result, referring to Table 1, the second inorganic encapsulation layer IEL2 satisfying Embodiment 2 may have lower moisture permeability than the second inorganic encapsulating layer satisfying Comparative Example 3. Thus, the second inorganic encapsulation layer IEL2 satisfying Embodiment 2 may have improved barrier properties compared to the second inorganic encapsulating layer satisfying Comparative Example 3.

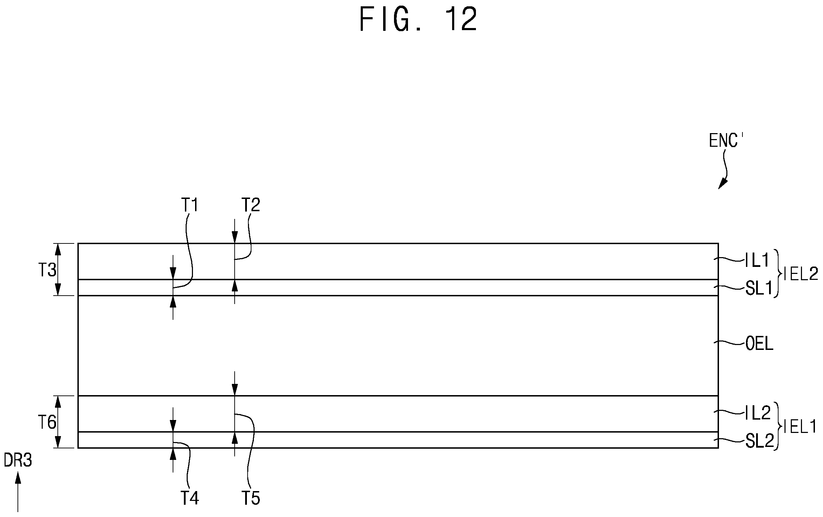

FIG. 12 is a schematic cross-sectional view illustrating another example of the encapsulation member ENC' of FIG. 3.

Referring to FIG. 12, an encapsulation member ENC' may include a first inorganic encapsulation layer IEL1, an organic encapsulation layer OEL disposed on the first inorganic encapsulation layer IEL1, and a second inorganic encapsulation layer IEL2 disposed on the organic encapsulation layer OEL. The encapsulation member ENC' described with reference to FIG. 12 may be substantially the same as or similar to the encapsulation member ENC described with reference to FIG. 4 except for the first inorganic encapsulation layer IEL1. Hereinafter, overlapping descriptions are omitted or simplified.

The first inorganic encapsulation layer IEL1 may include a silicon compound. In an embodiment, the first inorganic encapsulation layer IEL1 may include silicon nitride. In another embodiment, the first inorganic encapsulation layer IEL1 may include silicon oxynitride. However, embodiments are not limited thereto.

The first inorganic encapsulation layer IEL1 may be separated into two layers. In an embodiment, the first inorganic encapsulation layer IEL1 may include a second seed layer SL2 and a second inorganic layer IL2 disposed on the second seed layer SL2. For example, the second inorganic layer IL2 may contact (e.g., directly contact) the second seed layer SL2 and the organic encapsulation layer OEL. The second seed layer SL2 may be formed before the second inorganic layer IL2 by a separate deposition process.

The second seed layer SL2 may be substantially the same as the first seed layer SL1. For example, like the first seed layer SL1, the second seed layer SL2 may have silicon atoms and nitrogen atoms arranged uniformly and densely.

A density of the second inorganic layer IL2 may be less than a density of the second seed layer SL2. For example, the density of the second seed layer SL2 may be greater than the density of the second inorganic layer IL2. For example, the density of the second seed layer SL2 may be in the range of about 1.9 g/cm³ or more to about 3.5 g/cm³ or less. For example, the density of the second seed layer SL2 may be in the range of about 2.14 g/cm³ or more to about 2.7 g/cm³ or less. For example, the density of the second inorganic layer IL2 may be in the range of about 1.8 g/cm³ or more to about 3.5 g/cm³ or less. For example, the density of the second inorganic layer IL2 may be in the range of about 1.9 g/cm³ or more to about 2.04 g/cm³ or less.

In an embodiment, the difference between the density of the second seed layer SL2 and the density of the second inorganic layer IL2 may be in the range of about 0.1 g/cm³ or more. For example, the difference between the density of the second seed layer SL2 and the density of the second inorganic layer IL2 may be in the range of about 0.1 g/cm³ or more to about 1 g/cm³ or less.

For example, a thickness T6 of the first inorganic encapsulation layer IEL1 may be in the range of about 4,000 angstroms (Å) or less. For example, in case that the difference between the density of the second seed layer SL2 and the density of the second inorganic layer IL2 is in the range of about 0.1 g/cm³ or more to about 1 g/cm³ or less, the thickness T6 of the first inorganic encapsulation layer IEL1 may be in the range of about 4,000 Angstroms (Å) or less. Accordingly, the first inorganic encapsulation layer IEL1 may have a relatively thin thickness (compared to the first inorganic encapsulation layer IEL1 of FIG. 4).

For example, the thickness T6 of the first inorganic encapsulation layer IEL1 may denote the sum of a thickness T4 of the second seed layer SL2 and a thickness T5 of the second inorganic layer IL2. For example, the thickness T4, T5, or T6 of each layer may denote the length in the third direction DR3.

In an embodiment, the thickness T4 of the second seed layer SL2 may be about 10% or less of the thickness T6 of the first inorganic encapsulation layer IEL1. For example, the thickness T4 of the second seed layer SL2 may be about 0.01% or more to about 10% or less of the thickness T6 of the first inorganic encapsulation layer IEL1. In case that the thickness T4 of the second seed layer SL2 exceeds the thickness T6 of the first inorganic encapsulation layer IEL1 by about 10%, mass productivity may decrease due to a decrease in tact time (or manufacturing time).

The second seed layer SL2 and the second inorganic layer IL2 may be formed by different deposition processes. For example, the second seed layer SL2 may be formed by a first deposition process, and the second inorganic layer IL2 may be formed by a second deposition process different from the first deposition process.

For example, the first deposition process may be one of a plasma enhanced atomic layer deposition process, a sputtering process, and an E-beam vacuum deposition process. The second deposition process may be a plasma enhanced chemical vapor deposition process. However, embodiments are not limited thereto.

In case that the first inorganic encapsulation layer IEL1 includes silicon nitride, the second seed layer SL2 may be formed of an amino silane-based liquid precursor, and the second inorganic layer IL2 may be formed of a silane-based precursor or an amino silane-based liquid precursor.

The second inorganic encapsulation layer IEL2 of FIG. 12 may be substantially the same as the second inorganic encapsulation layer IEL2 of FIG. 4. As a result, the encapsulation member ENC' of FIG. 12 may include the first inorganic encapsulation layer IEL1 and the second inorganic encapsulation layer IEL2 that are substantially identical to each other.

In another embodiment, the organic encapsulation layer OEL may be omitted from the encapsulation member ENC', and the first inorganic encapsulation layer IEL1 or the second inorganic encapsulation layer IEL2 may be omitted. In another embodiment, the organic encapsulation layer OEL may be omitted from the encapsulation member ENC', and an inorganic encapsulation layer having a density lower than a density of the first and second inorganic encapsulation layers IEL1 and IEL2 may be further disposed between the first inorganic encapsulation layer IEL1 and the second inorganic encapsulation layer IEL2.

Embodiments may be applied to various display devices. For example, embodiments may be applicable to various display devices such as display devices for vehicles, ships and aircraft, portable communication devices, display devices for exhibition or information transmission, medical display devices, and the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the invention. Accordingly, all such modifications are intended to be included within the scope of the invention as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A display device comprising:
a display element layer (DL) disposed on a substrate (SUB) and including a light emitting element (LED); and
an encapsulation member (ENC, ENC') disposed on the display element layer and including:
a first inorganic encapsulation layer (IEL1);
an organic encapsulation layer (OEL) disposed on the first inorganic encapsulation layer; and
a second inorganic encapsulation layer (IEL2) including:
a first seed layer (SL1) disposed on the organic encapsulation layer and
a first inorganic layer (IL1) disposed on the first seed layer and having a density less than a density of the first seed layer.

2. The display device of claim 1, wherein a difference between the density of the first seed layer (IL1) and the density of the first inorganic layer (IL1) is in a range of 0.1 g/cm³ or more to 1 g/cm³ or less.

3. The display device of claim 1 or 2, wherein the second inorganic encapsulation layer (IEL1) has a thickness of 4,000 angstroms (Å) or less, and/or wherein a thickness of the first seed layer (IL1) is 10% or less of a thickness of the second inorganic encapsulation layer.

4. The display device of any of the preceding claims, wherein the first inorganic encapsulation layer (IEL1) includes:
a second seed layer (SL2) disposed on the display element layer; and
a second inorganic layer (IL2) disposed on the second seed layer and having a density less than a density of the second seed layer.

5. The display device of claim 4, wherein a difference between the density of the second seed layer (SL2) and the density of the second inorganic layer (IL2) is in a range of 0.1 g/cm³ or more to 1 g/cm³ or less.

6. The display device of claim 4 or 5, wherein the first inorganic encapsulation layer (IEL2) has a thickness of 4,000 angstroms (Å) or less, and/or wherein a thickness of the second seed layer (SL2) is 10% or less of a thickness of the first inorganic encapsulation layer (IEL1).

7. The display device of any of the preceding claims, wherein
the first inorganic encapsulation layer (IEL1) includes silicon oxide (SiNₓ) or silicon oxynitride (SiOₓN_{y}), and
the second inorganic encapsulation layer (IEL2) includes silicon nitride.

8. A method of manufacturing a display device, the method comprising:
forming a display element layer (DL) including a light emitting element on a substrate;
forming a first inorganic encapsulation layer (IEL1) on the display element layer;
forming an organic encapsulation layer (OEL) on the first inorganic encapsulation layer (IEL1);
forming a first seed layer (SL1) on the organic encapsulation layer by a first deposition process; and
forming a second inorganic encapsulation layer (IEL2) by forming a first inorganic layer (IL1) on the first seed layer by a second deposition process different form the first deposition process.

9. The method of claim 8, wherein the second deposition process is a plasma enhanced chemical vapor deposition (PECVD) process, and/or wherein the first deposition process is one of a plasma enhanced atomic layer deposition (PEALD) process, a sputtering process, and an E-beam vacuum deposition process.

10. The method of claim 8 or 9, wherein
a density of the first seed layer (SL1) is greater than a density of the first inorganic layer (IL1), and
a difference between the density of the first seed layer (SL1) and the density of the first inorganic layer (IEL1) is in a range of 0.1 g/cm³ or more to 1 g/cm³ or less.

11. The method of any of claims 8 to 10, wherein the second inorganic encapsulation layer (IEL2) has a thickness of 4,000 angstroms (Å) or less, and/or, wherein a thickness of the first seed layer (SL1) is 10% or less of a thickness of the second inorganic encapsulation layer (IEL2).

12. The method of any of claims 8 to 11, wherein the forming the first inorganic encapsulation layer (IEL1) includes:
forming a second seed layer (SL2) by the first deposition process; and
forming a second inorganic layer (IL2) on the second seed layer by the second deposition process.

13. The method of claim 12, wherein
a density of the second seed layer (SL2) is greater than a density of the second inorganic layer (IL2), and
a difference between the density of the second seed layer (SL2) and the density of the second inorganic layer (IL2) is in a range of 0.1 g/cm³ or more to 1 g/cm³ or less.

14. The method of claim 12 or 13, wherein
the first inorganic encapsulation layer (IEL1) has a thickness of 4,000 angstroms (Å) or less, and
a thickness of the second seed layer is 10% or less of a thickness of the first inorganic encapsulation layer (IEL1).

15. The method of any of claims 8 to 14, wherein
the first inorganic encapsulation layer (IEL1) includes silicon oxide or silicon oxynitride, and
the second inorganic encapsulation layer (IEL2) includes silicon nitride, and/or wherein the first seed layer (SL1) includes an amino silane-based liquid precursor.
